# EUROPEAN PATENT SPECIFICATION

(11) **EP 3 499 339 B1**
(45) Date of publication and mention of the grant of the patent: **24.11.2021**
(21) Application number: 17206977.5
(22) Date of filing: 13.12.2017
(51) Int. Cl.: G06F 1/20, H05K 7/20

(54) **ELECTRONICS DEVICE AND METHOD OF COOLING**
ELEKTRONIKVORRICHTUNG UND VERFAHREN ZUR KÜHLUNG
DISPOSITIF ÉLECTRONIQUE ET PROCÉDÉ DE REFROIDISSEMENT

(43) Date of publication of application: 19.06.2019
(73) Proprietor: Vestel Elektronik Sanayi ve Ticaret A.S., 45030 Manisa (TR)
(72) Inventor: DEMIR, Murat, 45030 Manisa (TR); KAHRAMANOGLU, Gürmen, 45030 Manisa (TR)
(74) Representative: Flint, Adam

(56) References cited:
- US-A1- 2003 053 293
- US-A1- 2011 138 406
- US-A1- 2012 170 206

## Description

### Technical Field

The present disclosure relates to an electronics device and a method of cooling a part of an electronics device.

### Background

All electronic devices generate heat during operation. Excessive heat can cause problems to electronic devices and their components, including for example circuit boards and electronics components. As processing demands increase, overheating of components is an increasing problem. Whilst for example additional cooling fans can be added, these can increase the cost of manufacture of the device, result in increased running noise, and can be a point of failure.

US2011138406A1 discloses an electronic device comprises a housing that holds an optical disk. The housing comprises a holding space holding the optical disk, a first internal space being apart from the holding space and in which a first electronic component controlling a pickup is disposed, an intake channel leading from the first internal space to the holding space, and an exhaust channel leading from the holding space to a specific space being distinct from the first internal space.

US2003053293A1 discloses a cooling system configured to supply individually metered amounts of cooling fluid to heat-generating components of an electronic system. The cooling system includes at least one variable speed fan configured to supply fluid through a centralised plenum and thereafter through a plurality of nozzles to the components of the electronic system. Each of the nozzles contains a valve to control the amount of fluid flow through the each of the nozzles.

US2012170206A1 discloses an electronic device which includes a cover, a motherboard and a driving module both disposed at an inner side of the cover, an electronic component fixed on the motherboard, and a fan duct mounted on the motherboard and covering the electronic component. The driving module has a rotating shaft for supportively driving an optical disk rotating. The fan duct guides hot air therein toward the driving module.

### Summary

According to a first aspect disclosed herein, there is provided an electronics device, the electronics device comprising:
a circuit board;
an electronics component; and
a rotating disk player;
the rotating disk player having an air flow inlet to receive air from the exterior of the electronics device and an air flow outlet arranged such that air flow generated by a disk rotating in the rotating disk player causes air to flow from the exterior of the electronics device through the air flow inlet and out through the air flow outlet towards at least one of the circuit board and the electronics component to cool the at least one of the circuit board (3) and the electronics component.

The component may be for example a processor, which may be for example a central processing unit, a video processor, a sound processor, etc. The component may be for example RAM (random access memory), or part of a power supply transformer, a hard disk drive, a solid state drive, etc.

The circuit board may be for example a mainboard, a power board, etc.

The rotating disk player may be for example a CD player/writer, a DVD player/writer, a Blu Ray player/writer, etc.

In an example, the electronics device comprises a duct for directing air from the rotating disk player to at least one of the circuit board and the electronics component.

The duct may be arranged, or there may be plural ducts, to direct air (optionally only when needed) to each of the circuit board(s) and the electronics component(s) that may need cooling.

In an example, the electronics device comprises one or more valves for controlling the flow of air through the duct to direct the air towards a selected one or selected ones of the circuit board and the electronics component.

In an example, the electronics device comprises a temperature sensor for detecting the temperature of at least one of the circuit board and the electronics component and for controlling the flow of air towards a selected one of the circuit board and the electronics component depending on the temperature of the at least one of the circuit board and the electronics component.

Each of the circuit board(s) and the electronics component(s) that may need cooling may have a temperature sensor for detecting their respective temperatures, and the air flow is controlled to be delivered to any circuit board and the electronics component that needs cooling based on its temperature.

In an example, the electronics device comprises a vent to the exterior through which air that has flowed from the rotating disk player to said at least one of the circuit board and the electronics component can escape.

According to a second aspect disclosed herein, there is provided a method of cooling a part of an electronics device, the electronics device comprising a circuit board, an electronics component and a rotating disk player, the method comprising:
rotating a disk in the rotating disk player to cause air flow generated by the rotating disk to flow from the exterior of the electronics device through an air flow inlet of the rotating disk player and out through an air flow outlet of the rotating disk player towards at least one of the circuit board and the electronics component to cool the at least one of the circuit board and the electronics component.

In an example, the method comprises directing the air from the rotating disk player through a duct to at least one of the circuit board and the electronics component.

In an example, the method comprises operating one or more valves to control the flow of air through the duct to direct the air towards a selected one or selected ones of the circuit board and the electronics component.

In an example, the method comprises detecting the temperature of at least one of the circuit board and the electronics component, and controlling the flow of air towards a selected one of the circuit board and the electronics component depending on the temperature of the at least one of the circuit board and the electronics component.

### Brief Description of the Drawings

To assist understanding of the present disclosure and to show how embodiments may be put into effect, reference is made by way of example to the accompanying drawings in which:
Figure 1 shows schematically a view from one side of an electronics device as described herein;
Figure 2 shows schematically a view from another side of an electronics device as described herein; and
Figure 3 shows schematically an arrangement of a duct and a valve for an electronics device.

### Detailed Description

As is well known, all electronic devices generate heat during operation. Excessive heat can cause problems to electronic devices and their components, including for example circuit boards and electronics components. Whilst additional cooling fans can be provided, these increase the cost of the electronic device and can add to the running noise of the electronic device, as well as being another source of failure.

Examples described herein enable one or more components of an electronic device to be cooled, without requiring for example a cooling fan, or at least an additional cooling fan, to be included in the device. Air flow generated by a disk rotating in a rotating disk player of the device is arranged to flow towards at least one component, i.e. a circuit board or an electronics component of the device, to cool the component.

The electronics device may be for example a media device such as a television, a set top box, a PVR (personal video recorder), a DVD player, a Blu Ray player, a personal computing device such as a laptop or desktop or tablet computer, a video game console, etc.

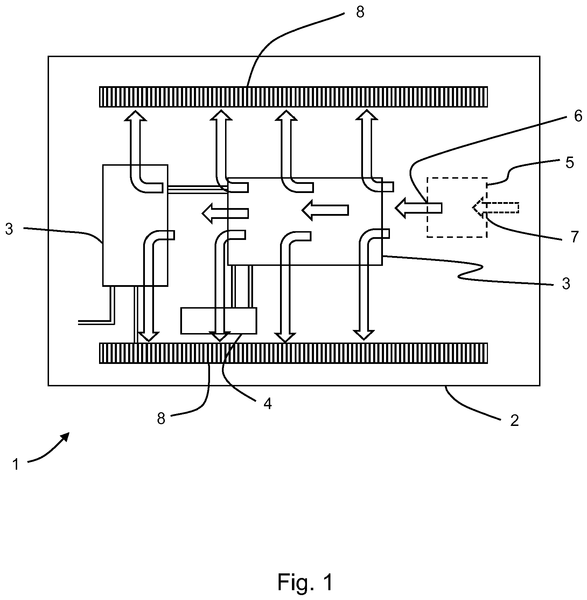

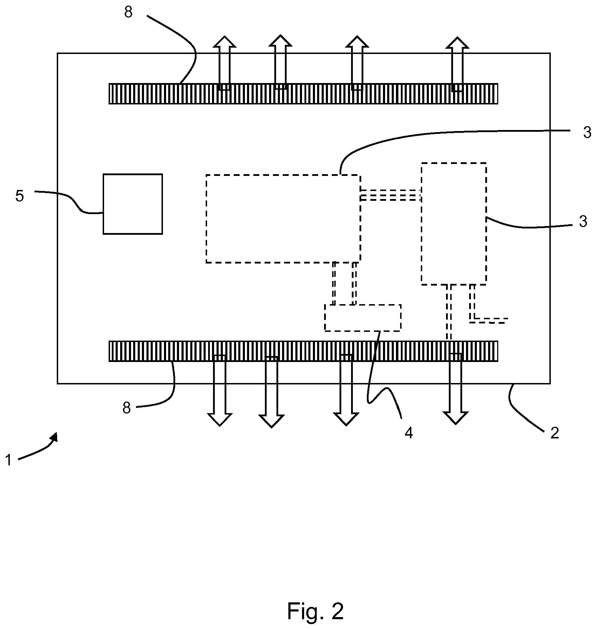

Referring now to the drawings, Figure 1 shows schematically a view from the interior of an electronics device 1 looking towards an outer wall 2 of the electronics device 1 and Figure 2 shows schematically a view from the exterior of the electronics device 1 looking towards the same outer wall 2 of the electronics device 1. The wall 2 may be for example one of the outer walls of the main housing or case of the electronics device 1.

The electronics device 1 has at least one circuit board 3. The circuit board may be a printed circuit board and may be for example a mainboard, a power board, etc., as is well known in electronics devices generally and consumer products in particular. For example, most televisions and other display devices comprise a PCB, often referred to as a "mainboard", for controlling the display and other functions. Most televisions and other display devices also have a power board, which includes or is connected to a voltage transformer to provide supply voltages from an incoming mains power supply to one or more components of the device.

The electronics device 1 has at least one electronics component 4. The component may be for example a processor, which may be for example a central processing unit, a video processor, a sound processor, etc. The component may be for example RAM (random access memory), or part of a power supply transformer, a hard disk drive, a solid state drive, etc. In the drawings, the electronics component 4 is shown separately of the circuit boards 3. However, as is common, the circuit boards 3 may also have one or more electronics components 4 mounted thereon, in addition to passive electrical components such as resistors, capacitors and inductors.

The electronics device 1 further has at least one rotating disk player 5. The rotating disk player 5 may be for example a CD player/writer (i.e. a CD player only or a combined CD player and writer), a DVD player/writer, a Blu Ray player/writer, or other optical or magneto-optical disk player/writer. (Because, as will be explained below, air flow out of the rotating disk player 5 is required, it is in most cases unlikely that the rotating disk player 5 may be a hard disk drive as hard disk drives tend to be (substantially) sealed to prevent contaminants striking and adhering to the delicate surface of the hard disk. Nevertheless, it may be possible to implement the broad concepts described herein with a suitably adapted or arranged hard disk player.)

The circuit board(s) 3 and the electronics component(s) 4 are shown in the figures as being internal to the electronics device 1. The rotating disk player 5 is shown in the figures as being external to the electronics device 1. The external mounting of the rotating disk player 5 makes it easier for a user to access a disk loading tray or slot or the like of the rotating disk player 5, and also helps to keep down the temperature of the rotating disk player 5 during use. Nevertheless, in other examples the rotating disk player 5 may be provided internally of the electronics device 1; a slot with an optional cover or the like may be provided in the wall 2 to allow disks to be inserted and removed as desired in such a case.

The rotating disk player 5 has at least one air flow outlet 6 through which air can flow from within the main body or housing of the rotating disk player 5 outwardly to the exterior of the rotating disk player 5. In this regard, it is noted that rotating disk players, particularly optical disk players or opto-magnetic disk players, are commonly provided in the form of a generally cuboid box with a caddy that can slide in and out to allow a disk to be inserted and removed. The box of a conventional rotating disk player typically has one or more small air holes to allow air to enter and exit the box, largely to maintain an even pressure within the box during rotation of the disk and allow air in to cool the disk player itself. As used herein, the rotating disk player 5 may have a relatively large air flow outlet 6 to encourage the flow of air out of the rotating disk player 5.

Moreover, the air flow outlet 6 of the rotating disk player 5 is arranged so as to direct air towards one or more of the at least one circuit board 3 and electronics component 4. In this example, the rotating disk player 5 is located towards one side of all of the circuit board(s) 3 and electronics component(s) 4. Accordingly, the air flow outlet 6 is located in this example on the side or face of the rotating disk player 5 that is towards circuit board(s) 3 and electronics component(s) 4. The rotating disk player 5 may have one or more air inlets on one or more other sides. The rotating disk player 5 in one example has at least one air inlet 7 on the side opposite the air flow outlet 6, which encourages the flow of air through the rotating disk player 5.

The electronics device 1 has one or more air outlets or vents 8 through which air can escape from the interior of the electronics device 1 to the exterior. The air outlets 8 are arranged in this example to be located generally near where air has passed over the circuit board(s) 3 and electronics component(s) 4 to allow that air to escape from the interior of the electronics device 1. In this example, the air outlets 8 are arranged as elongate cooling apertures running along the top and bottom of the wall 2 of the electronics device 1.

Air flow through the electronics device 1 during operation is shown schematically by arrows in the drawings. Air exiting the air flow outlet 6 of the rotating disk player 5 passes over one or more of the circuit board(s) 3 and electronics component(s) 4. In doing so, the air can cool the circuit board(s) 3 and/or electronics component(s) 4. The air exiting the rotating disk player 5 will in general be at a lower temperature than the circuit board(s) 3 and electronics component(s) 4, or at least some of the circuit board(s) 3 and electronics component(s) 4, which facilitates the cooling effect. The air that has passed over and been warmed by the circuit board(s) 3 and electronics component(s) 4 can then exit the electronics device 1 through the air outlets or vents 8 of the electronics device 1.

Accordingly, by using air flow, which has been generated in use by a rotating disk player 5, the electronic device 1 can cool one or more of circuit board(s) 3 and electronics component(s) 4 without requiring additional cooling fans or other measures to be put in place to achieve the cooling.

The rotating disk player 5 may have one or more features that encourage air flow through the rotating disk player 5. For example, the rotating disk player 5 may be provided internally with one or more baffles, depressions or pits, and mounds or protrusions, which may be tailored to promote air flow through the rotating disk player 5. This may be achieved by the one or more features giving rise to local pressure changes, which can help force air in and out of the rotating disk player 5 as desired.

The rotating disk player 5 may have one or more ducts through which the air from the rotating disk player 5 flows to the one or more circuit board(s) 3 and electronics component(s) 4. The ducts may be for example tubes or passageways or the like, which have an inlet facing the outlet 6 of the rotating disk player 5 and which have outlets positioned over the (portions of the) one or more circuit board(s) 3 and electronics component(s) 4 that need to be cooled.

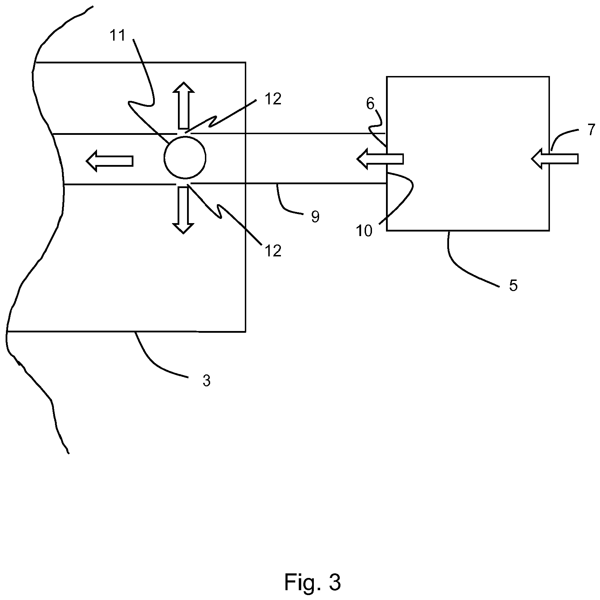

Moreover, the ducts may be provided with valves or the like to control the air flow. For example, the valves may be controlled to open or close a portion of a duct so as to determine whether or not air flows through that duct over the associated (portion of the) circuit board 3 or electronics component 4 that needs to be cooled. An example of this is indicated schematically in Figure 3. An air duct 9, in the form of a tube, has an air inlet 10 which faces the air outlet 6 of the rotating disk player 5 to receive air exiting the rotating disk player 5. The duct 9 has a valve 11 which can be selectively controlled to allow or prevent air flowing through the duct 9 to exit through one or more apertures 12 in a side wall of the duct 9 to flow out over an associated circuit board 3 (in the example shown in Figure 3) or an electronics component 4. A number of such valves 11 and associated exit apertures 12 and/or valves 11 with associated openings to further ducts which themselves then relay cooling air to the circuit board(s) 3 and electronics component(s) 4 that need to be cooled may be provided. The or each valve 11 may take one of a number of forms, including for example gates, doors, sliders, etc.

To improve the control of the air flow, one or more of the circuit board(s) 3 and electronics component(s) 4 that need to be cooled may have temperature sensors. The outputs of the temperature sensors may be used to determine which circuit board(s) 3 and electronics component(s) 4 has/have a particular need for cooling at any particular point in time. In the case that the air flow can be controlled to be directed at particular one(s) of the circuit board(s) 3 and electronics component(s) 4, for example in the case that there is one or more ducts 9 and one or more control valves to direct the air flow, the output of the temperature sensors can be used to control the opening and closing of the valve(s), either directly or under some processor control.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may also be used in combination with one or more features of any other of the examples or embodiments, or any combination of any other of the examples or embodiments. Furthermore, modifications not described herein may also be employed within the scope of the invention, which is defined in the claims.

## Claims

1. An electronics device (1), the electronics device (1) comprising:
a circuit board (3);
an electronics component (4); and
a rotating disk player (5);
the rotating disk player (5) having an air flow inlet (7) to receive air from the exterior of the electronics device (1) and an air flow outlet (6) arranged such that air flow generated by a disk rotating in the rotating disk player (5) causes air to flow from the exterior of the electronics device (1) through the air flow inlet (7) and out through the air flow outlet (6) towards at least one of the circuit board (3) and the electronics component (4) to cool the at least one of the circuit board (3) and the electronics component (4).

2. An electronics device (1) according to claim 1, comprising a duct (9) for directing air from the rotating disk player (5) to at least one of the circuit board (3) and the electronics component (4).

3. An electronics device (1) according to claim 2, comprising one or more valves (11) for controlling the flow of air through the duct (9) to direct the air towards a selected one or selected ones of the circuit board (3) and the electronics component (4).

4. An electronics device (1) according to claim 3, comprising a temperature sensor for detecting the temperature of at least one of the circuit board (3) and the electronics component (4) and for controlling the flow of air towards a selected one of the circuit board (3) and the electronics component (4) depending on the temperature of the at least one of the circuit board (3) and the electronics component (4).

5. An electronics device (1) according to any of claims 1 to 4, comprising a vent to the exterior through which air that has flowed from the rotating disk player (5) to said at least one of the circuit board (3) and the electronics component (4) can escape.

6. An electronics device (1) according to any of claims 1 to 5, the rotating disk player (5) being mounted externally of a housing of the electronics device (1).

7. A method of cooling a part of an electronics device (1), the electronics device (1) comprising a circuit board (3), an electronics component (4) and a rotating disk player (5), the method comprising:
rotating a disk in the rotating disk player (5) to cause air flow generated by the rotating disk to flow from the exterior of the electronics device (1) through an air flow inlet (7) of the rotating disk player (5) and out through an air flow outlet (6) of the rotating disk player (5) towards at least one of the circuit board (3) and the electronics component (4) to cool the at least one of the circuit board (3) and the electronics component (4).

8. A method according to claim 7, comprising directing the air from the rotating disk player (5) through a duct (9) to at least one of the circuit board (3) and the electronics component (4).

9. A method according to claim 8, comprising operating one or more valves (11) to control the flow of air through the duct (9) to direct the air towards a selected one or selected ones of the circuit board (3) and the electronics component (4).

10. A method according to claim 9, comprising detecting the temperature of at least one of the circuit board (3) and the electronics component (4), and controlling the flow of air towards a selected one of the circuit board (3) and the electronics component (4) depending on the temperature of the at least one of the circuit board (3) and the electronics component (4).

11. A method according to any of claims 7 to 10, wherein the rotating disk player (5) is mounted externally of a housing of the electronics device (1).

## Patentansprüche

1. Elektrogerät (1), wobei das Elektrogerät (1) aufweist:
eine Leiterplatte (3);
eine Elektronikkomponente (4); und
einen Drehplattenspieler (5);
wobei der Drehplattenspieler (5) einen Luftstromeinlass (7), um Luft von außerhalb des Elektrogeräts (1) aufzunehmen, und einen Luftstromauslass (6), der so arrangiert ist, das der durch eine im Drehplattenspieler (5) drehende Platte erzeugte Luftstrom Luft von außerhalb des Elektrogeräts (1) durch den Luftstromeinlass (7) und durch den Luftstromauslass (6) heraus zu wenigstens einer der Leiterplatte (3) und der Elektronikkomponente (4) strömen lässt, um die wenigstens eine der Leiterplatte (3) und der Elektronikkomponente (4) zu kühlen, aufweist.

2. Elektrogerät (1) nach Anspruch 1, aufweisend einen Kanal (9) zum Leiten der Luft vom Drehplattenspieler (5) zu wenigstens einer der Leiterplatte (3) und der Elektronikkomponente (4).

3. Elektrogerät (1) nach Anspruch 2, aufweisend ein oder mehr Ventile (11) zum Steuern des Luftstroms durch den Kanal (9), um die Luft zu einer ausgewählten oder zu ausgewählten der Leiterplatte (3) und der Elektronikkomponente (4) zu leiten.

4. Elektrogerät (1) nach Anspruch 3, aufweisend einen Temperatursensor zum Erfassen der Temperatur von wenigstens einer der Leiterplatte (3) und der Elektronikkomponente (4) und zum Steuern des Luftstroms zu einer ausgewählten der Leiterplatte (3) und der Elektronikkomponente (4) in Abhängigkeit von der Temperatur der wenigstens einen der Leiterplatte (3) und der Elektronickomponente (4).

5. Elektrogerät (1) nach einem der Ansprüche 1 bis 4, aufweisend eine Entlüftung nach außen, durch die Luft austreten kann, die vom Drehplattenspieler (5) zu der wenigstens einen der Leiterplatte (3) und der Elektronikkomponente (4) geströmt ist.

6. Elektrogerät (1) nach einem der Ansprüche 1 bis 5, wobei der Drehplattenspieler (5) extern eines Gehäuses des Elektrogeräts (1) montiert ist.

7. Verfahren zum Kühlen eines Teils eines Elektrogeräts (1), wobei das Elektrogerät (1) eine Leiterplatte (3), eine Elektronikkomponente (4) und einen Drehplattenspieler (5) aufweist, wobei das Verfahren aufweist:
Drehen einer Platte im Drehplattenspieler (5), um einen durch die drehende Platte erzeugten Luftstrom von außerhalb des Elektrogeräts (1) durch einen Luftstromeinlass (7) des Drehplattenspielers (5) und durch einen Luftstromauslass (6) des Drehplattenspielers (5) heraus zu wenigstens einer der Leiterplatte (3) und der Elektronikkomponente (4) strömen zu lassen, um die wenigstens eine der Leiterplatte (3) und der Elektronikkomponente (4) zu kühlen.

8. Verfahren nach Anspruch 7, aufweisend ein Leiten der Luft vom Drehplattenspieler (5) durch einen Kanal (9) zu wenigstens einer der Leiterplatte (3) und der Elektronikkomponente (4).

9. Verfahren nach Anspruch 8, aufweisend ein Betätigen von ein oder mehr Ventilen (11), um den Luftstrom durch den Kanal (9) zu steuern, um die Luft zu einer ausgewählten oder zu ausgewählten der Leiterplatte (3) und der Elektronickomponente (4) zu leiten.

10. Verfahren nach Anspruch 9, aufweisend ein Erfassen der Temperatur von wenigstens einer der Leiterplatte (3) und der Elektronikkomponente (4) und ein Steuern des Luftstroms zu einer ausgewählten der Leiterplatte (3) und der Elektronikkomponente (4) in Abhängigkeit von der Temperatur der wenigstens einen der Leiterplatte (3) und der Elektronikkomponente (4).

11. Verfahren nach einem der Ansprüche 7 bis 10, wobei der Drehplattenspieler (5) extern eines Gehäuses des Elektrogeräts (1) montiert ist.

## Revendications

1. Dispositif électronique (1), le dispositif électronique (1) comprenant :
une carte de circuit (3) ;
un composant électronique (4) ; et
un lecteur de disque rotatif (5) ;
le lecteur de disque rotatif (5) ayant une entrée de flux d'air (7) pour recevoir de l'air provenant de l'extérieur du dispositif électronique (1), et une sortie de flux d'air (6) agencée de sorte qu'un flux d'air généré par un disque tournant dans le lecteur de disque rotatif (5) permette à de l'air provenant de l'extérieur du dispositif électronique (1) de circuler à travers l'entrée de flux d'air (7) et de sortir à travers la sortie de flux d'air (6) vers au moins l'un de la carte de circuit (3) et du composant électronique (4) afin de refroidir ledit au moins l'un de la carte de circuit (3) et du composant électronique (4).

2. Dispositif électronique (1) selon la revendication 1, comprenant un conduit (9) destiné à diriger de l'air du lecteur de disque rotatif (5) vers au moins l'un de la carte de circuit (3) et du composant électronique (4).

3. Dispositif électronique (1) selon la revendication 2, comprenant une ou plusieurs vannes (1) destiné à contrôler le flux d'air à travers le conduit (9) pour diriger l'air vers l'un ou plusieurs sélectionnés parmi la carte de circuit (3) et le composant électronique (4).

4. Dispositif électronique (1) selon la revendication 3, comprenant un capteur de température destiné à détecter la température d'au moins l'un de la carte de circuit (3) et du composant électronique (4), et destiné à contrôler le flux d'air vers l'un sélectionné parmi la carte de circuit (3) et le composant électronique (4) en fonction de la température dudit au moins l'un de la carte de circuit (3) et du composant électronique (4).

5. Dispositif électronique (1) selon l'une quelconque des revendications 1 à 4, comprenant un évent vers l'extérieur à travers lequel l'air qui a circulé du lecteur de disque rotatif (5) vers ledit au moins l'un de la carte de circuit (3) et du composant électronique (4) peut s'échapper.

6. Dispositif électronique (1) selon l'une quelconque des revendications 1 à 5, le lecteur de disque rotatif (5) étant monté à l'extérieur d'un boîtier du dispositif électronique (1).

7. Procédé de refroidissement d'une partie d'un dispositif électronique (1), le dispositif électronique (1) comprenant une carte de circuit (3), un composant électronique (4) et un lecteur de disque rotatif (5), le procédé consistant à :
faire tourner un disque dans le lecteur de disque rotatif (5) pour permettre à un flux d'air généré par le disque rotatif de circuler de l'extérieur du dispositif électronique (1) à travers une entrée de flux d'air (7) du lecteur de disque rotatif (5) et de sortir à travers une sortie de flux d'air (6) du lecteur de disque rotatif (5) vers au moins l'un de la carte de circuit (3) et du composant électronique (4) pour refroidir ledit au moins l'un de la carte de circuit (3) et du composant électronique (4).

8. Procédé selon la revendication 7, consistant à diriger l'air du lecteur de disque rotatif (5) à travers un conduit (9) vers au moins l'un de la carte de circuit (3) et du composant électronique (4).

9. Procédé selon la revendication 8, consistant à mettre en fonctionnement une ou plusieurs vannes (11) pour contrôler le flux d'air à travers le conduit (9) pour diriger l'air vers l'un ou plusieurs sélectionnés parmi la carte de circuit (3) et le composant électronique (4).

10. Procédé selon la revendication 9, consistant à détecter la température d'au moins l'un de la carte de circuit (3) et du composant électronique (4), et à contrôler le flux d'air vers l'un sélectionné parmi la carte de circuit (3) et le composant électronique (4) en fonction de la température dudit au moins l'un de la carte de circuit (3) et du composant électronique (4).

11. Procédé selon l'une quelconque des revendications 7 à 10, dans lequel le lecteur de disque rotatif (5) est monté à l'extérieur d'un boîtier du dispositif électronique (1).
